Europäisches Patentamt

European Patent Office

Office européen des brevets

(19)

(11) Publication number : **0 474 499 A2**

## (12) EUROPEAN PATENT APPLICATION

(21) Application number : 91308157.6

(22) Date of filing : 05.09.91

(51) Int. Cl.⁵ : **H01L 23/495**

(30) Priority : 05.09.90 JP 234833/90

(43) Date of publication of application :
11.03.92 Bulletin 92/11

(84) Designated Contracting States :
DE FR GB

(71) Applicant : **SHINKO ELECTRIC INDUSTRIES CO. LTD.**
**711, Aza Shariden Oaza Kurita**
**Nagano-shi Nagano, 380 (JP)**

(72) Inventor : **Wakabayashi, Norio**
**436 Kurita**
**Nagano-shi, Nagano (JP)**
Inventor : **Murata, Akihiko**
**408 Nishiowaribe**
**Nagano-shi, Nagano (JP)**

(74) Representative : **Rackham, Stephen Neil et al**
**GILL JENNINGS & EVERY 53-64 Chancery Lane**
**London WC2A 1HN (GB)**

(54) Lead frame for a semiconductor device.

(57) A lead frame (10) for a semiconductor device comprising : a lead frame material made of a metal strip (20) and including at least a plurality of inner (14) and outer (12) leads, a Pd or Pd-alloy film (24) formed directly or via an underlayer film (26) on an entire surface of the lead frame material ; and an Ag- or Au-plated film (28) further formed on the Pd or Pd-alloy film (24) of at least said outer leads (12) of the lead frame material.

# Fig. 2

EP 0 474 499 A2

This invention relates to a lead frame used for a semiconductor device.

A semiconductor device comprises a lead frame having a chip mounting or die-pad area and a plurality of leads around the die-pad area, a semiconductor chip mounted on the die-pad area and having a plurality of connecting terminals, metal wires for connecting tips of the respective leads to the terminals of the semiconductor chip, and a mold resin material for hermetically sealing at least a region including the semiconductor chip and the tips of the leads around the chip.

In such a lead frame for a semiconductor device, a stable and easy soldering connection is required, for example, when a semiconductor chip is mounted on the lead frame by a soldering process, when the semiconductor chip is connected to inner leads via wires by a bonding process, and when outer leads are connected to outside terminals.

In order to obtain a lead frame having a good abutting characteristic for a semiconductor chip and a good wire-bonding characteristic, it is known in the art to form a thin plated film of Ag or Au on the die-pad area and the inner lead portions. However, such a method for forming a thin plated film of Ag or Au on the die-pad area and the inner lead portions requires laborious and wasteful work.

Recently, however, a lead frame has been disclosed which the chip mounting area, the inner lead portions and the outer lead portions are coated with a film of Pd or Pd-alloy. See Japanese Examined Patent Publication (Kokoku) No. 63-49382 (Kokai No. 59-168659).

The film of Pd or Pd-alloy is chemically stable and, therefore, useful for good abutting characteristic for obtaining a semiconductor chip, good wire-bonding characteristic, and good wetting characteristic. Therefore, the film of Pd or Pd-alloy makes it possible to improve the wetting characteristic of the outer leads. Also, since the entire surface of the lead frame is coated with the film of Pd or Pd-alloy, a process for plating it is simple.

However, the above-mentioned lead frame still has the following problems.

Although the film of Pd or Pd-alloy is chemically stable and has a generally satisfactory wire-bonding characteristic, more severe, and more sophisticated characteristics have been recently required in some occasions. For example, although there are no problems in an abutting characteristic for a semiconductor chip and the wire-bonding characteristic, the film of Pd or Pd-alloy may deteriorate as a result of its heat history, for example, when the semiconductor chip is mounted on the chip mounting area. The wetting characteristic of the lead frame at a later process may thus be reduced.

Therefore, it is rather difficult to attain a required wet area ratio, for example, not less than 90 % and also it is difficult to attain a required wetting speed. Thus, it is necessary to dip the lead frame in a solder basin for a longer time.

An object of the present invention is to provide a lead frame for a semiconductor device having a good abutting or soldering characteristic.

According to this invention, a lead frame for a semiconductor device comprises: a lead frame material made of a metal strip and including at least a plurality of inner and outer leads, a Pd or Pd-alloy film formed directly or via an underlayer film on an entire surface of said lead frame material; and an Ag or Au-plated film further formed on said Pd or Pd-alloy film of at least said outer leads of the lead frame material.

In the present invention, the Ag or Au-plated film serves as a protective film for the underlayer of Pd or Pd-alloy film and, on the other hand, although the Ag or Au-plated film may be only very thin, there exists the underlayer of Pd or Pd-alloy film having a good characteristic, so the drawbacks of the two films can mutually be compensated for and the soldering characteristic of the outer leads can significantly be improved due to their cooperative effects. Particularly, the time necessary for wetting the solder can be significantly reduced.

A particular embodiment of a lead frame in accordance with this invention will now be described with reference to the accompanying drawings; in which:-

Figure 1 is a plan view of a lead frame according to the present invention; and,

Figure 2 is an enlarged cross-sectional view of an outer lead portion of the lead frame of the present invention.

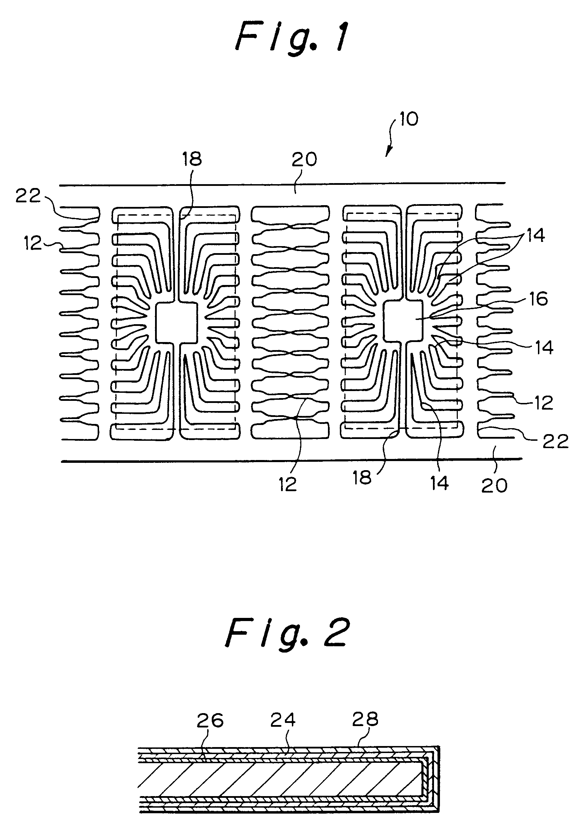

Referring now to the drawings, Figs. 1 and 2 show a preferred embodiment of a lead frame which can be used for a semiconductor device according to the present invention.

In the drawings, a lead frame generally indicated by reference numeral 10 is made of a metal strip, including outer leads 12, inner leads 14, and a chip mounting area or die pad 16, on which a semiconductor chip (not shown) is to be mounted, which are supported and connected via support bars 18 to upper and lower guide rails 20. A reference numeral 22 indicates dam bars.

After a certain metal film is formed on the surface of the lead frame 10, as will be described hereinafter in detail, a semiconductor chip (not shown) is mounted on the chip mounting area 16, the semiconductor chip is connected to the inner leads by bonding wires, and, then, the semiconductor device including at least the semiconductor chip and the inner leads around the chip is hermetically sealed with a mold resin material, whereby a semiconductor device is obtained. The outer leads of the semiconductor device are plated in advance with solder films or are plated with solder films when the semiconductor device is mounted on a circuit board (not shown). Thus, when the semiconductor device is mounted on a predetermined position on the circuit board, the outer leads are thus connected to a predetermined pattern thereon.

According to this invention, a Pd or Pd-alloy film is formed on the entire surface of the lead frame 10 and, then, an Ag-plated film or Au-plated film is further formed thereon.

Cu or Cu-alloy or Fe-Ni alloy can generally be used as a material of the lead frame, but the frame is not limited to a particular metal.

As shown in Fig. 2, according to the present invention, a Pd or Pd-alloy film 24 is formed on the material of the lead frame 10 via an underlayer consisting of, for example, a Ni-plated film or the like, or is directly formed on the material thereof, depending on the material, by itself. The Pd-alloy used in this invention may be a Pd-Ni alloy, Pd-Co alloy, Pd-Ag alloy, Pd-Cu alloy, or the like. Such a Pd or Pd-alloy film 24 can be formed by electroplating, electroless-plating, or any other thin film forming method, for example, a sputtering. The thickness of the Pd or Pd-alloy film 24 is advantageously not less than 0.1 μm.

The Ag-plated film or Au-plated film 28 may be formed on the entire surface of the lead frame 10 or at least on the outer leads 12 of the lead frame 10.

The Ag- or Au-plated film 28 is very thin, i.e., the thickness thereof is from a monatomic layer thickness to 0.1μm. Since the thickness of the Ag- or Au-plated film 28 is so small, the cost required for the purpose can significantly be reduced and, in case of Ag-plated film, a reduction of an electrical insulation characteristic or a short circuit between leads due to migration can advantageously be prevented.

Because it is necessary to form the Ag or Au-plated film 28 very thin, a general soldering basin is not suitable, since more severe plating conditions are thus required. Therefore, a particular soldering basin containing a very low density of Ag or Au, such as 5 to 1000 ppm of Ag or Au is used.

As mentioned above, in this invention, since an Ag-or Au-plated film is formed on an underlayer of a Pd or Pd-alloy film, the film of Pd or Pd-alloy can be prevented from being deteriorated due to the heat history of the lead frame 10, for example, when the semiconductor chip (not shown) is mounted thereon. Also, since the plated film of Ag or Au-alloy is chemically and thermally stable, the wire-bonding or soldering characteristic of the outer leads can significantly be improved. Consequently, the ratio of the soldering wet area can be improved and also the time necessary for wetting to obtain a predetermined wet area can be effectively shortened.

Since the thickness of the Ag- or Au-plated film 28 is very thin, such as from a monatomic layer thickness to 0.1μm, a good characteristic of the surface of the lead frame 10 can be obtained because it is composed of both the characteristic of the Pd or Pd-alloy and the characteristic of the Ag- or Au-plated film 28.

Generally, although an Ag- or Au-plated film has an inherently good soldering or wire-bonding characteristic, it should not be made thick in view of the cost performance and, in the case of an Ag-plated film, in view of generation of migration. On the other hand, if such an Ag- or Au-plated film is formed very thin on the material, for example, on a copper material, the latter may easily be oxidized to affect a soldering characteristic.

However, according to the present invention, the underlayer of Pd or Pd-alloy film is protected by the Ag or Au-plated film 28 and, on the other hand, although the Ag or Au-plated film 28 is very thin, there exists the underlayer of Pd or Pd-alloy film 24 having a good characteristic, so the drawbacks of the two films can mutually be compensated and the soldering characteristic of the outer leads can significantly be improved due to their cooperative effects.

If the Ag or Au-plated film 28 is formed on the chip mounting area 16 and the inner leads 14, when a semiconductor chip (not shown) is mounted on the chip mounting area 16 or when the inner leads 14 are connected by a wire-bonding process, the Ag or Au-plated film 28 is easily melted because of its very small thickness, and the chip-mounting or the wire-bonding can be effectively conducted on the underlayer of Pd or Pd-alloy film 24.

Otherwise, even if such an Ag- or Au-plated film 28 is not formed on the chip mounting area 16 and on the inner leads 14, the underlayer of Pd or Pd-alloy film 24 will not deteriorate, since no heat history is exerted thereon. Thus, the chip-mounting or the wire-bonding can be effectively conducted.

EXAMPLE 1

Two kinds of samples were prepared. One kind was made by forming a Ni-plated film having 1 μm thickness on a lead frame made of Cu material and, then, forming a Pd-plated film having 0.1 μm thickness thereon. The kind was made by forming an Ag-plated film having 0.01 μm thickness formed on the above samples. The comparative results of the soldering characteristics are shown in Table 1.

EP 0 474 499 A2

Table 1

| | Ni/Pd | | Ni/Pd/Ag | |
|---|---|---|---|---|
| | Ratio of wet area | Time | Ratio of wet area | Time |
| After heated under 310°C x 1 min. | 95% | 4sec. | 100% | 2 sec. |
| After heated under 330°C x 1 min. | 70% | 10 sec. | 100% | 3 sec. |

Temperature of soldering basin: 220
Components of Ag-plating basin:
KAg (CN)2:   10 - 2000 ppm
KCN           10 - 50 g/l

As will be clearly understood from Table 1, using the samples of Ni/Pd/Ag, the ratios of the soldering wet area were more improved and also the time necessary for wetting to obtain a predetermined wet area can be significantly shortened.

The same results as shown above were also obtained under the conditions of forming an Au-plated film in place of an Ag-plated film.

EXAMPLE 2

Two kinds of samples were prepared. One kind was made by forming Pd-plated film having 0.3 μm thickness on a lead frame made of 42 (JIS) alloy (Fe-Ni alloy). The other was made by forming and Ag-plated film having 0.005 μm thickness on said ones. The comparative results of soldering characteristics are shown in Table 2.

Table 2

| | Pd | | Pd/Ag | |
|---|---|---|---|---|
| | Ratio of wet area | Time | Ratio of wet area | Time |
| After heated under 310°C x 1 min. | 98% | 3 sec. | 100% | 2 sec. |
| After heated under 330°C x 1 min. | 80% | 9 sec. | 100% | 2.5 sec. |

Temperature of soldering basin: 220
Components of Ag-plating basin:
KAg (CN)2:   10 - 2000 ppm

KCN          10 - 50 g/l

As will be clearly understood from Table 2, using the samples of Pd/Ag, the ratios of soldering wet area were improved and also the time necessary for wetting to obtain a predetermined wet area can be significantly shortened. The same results as shown above were also obtained under the conditions of forming an Au-plated film in place of an Ag-plated film.

A lead frame obtained according to the present invention is used for making a semiconductor device as follows in a known manner. First, a semiconductor chip is mounted on the stage or die-pad portion of the lead frame in a die-bonding process. Then, wires are bonded to the semiconductor chip to be connected to the inner lead porions of the lead frame in a wire-bonding process. Then, the semiconducor chip, the stage and the inner lead portions are molded with a resin to hermetically seal them in a molding process. The outer lead portions are cut from each other and formed in a triming and forming process.

## Claims

1.  A lead frame (10) for a semiconductor device comprising:
    a lead frame material made of a metal strip (20) and including at least a plurality of inner (14) and outer leads (12),
    a Pd or Pd-alloy film (24) formed directly or via an underlayer film (26) on an entire surface of the lead frame material; and,
    an Ag or Au-plated film (28) further formed on the Pd or Pd-alloy film of at least the outer leads (12) of the lead frame material.

2.  A lead frame as set forth in claim 1, wherein a thickness of the Ag or Au-plated film is within a range from a monatomic layer thickness to 0.1 $\mu$m.

3.  A lead frame as set forth in claim 1 or 2, wherein said Pd-alloy is Pd-Ni alloy, Pd-Co alloy, Pd-Ag alloy, or Pd-Cu alloy formed by an electroplating, electroless-plating, or sputtering.

4.  A lead frame as set forth in any one of the preceding claims, wherein the thickness of the Pd or Pd-alloy film is not less than 0.1 $\mu$m.

# Fig. 1

# Fig. 2